# EUROPEAN PATENT SPECIFICATION

(11) **EP 3 518 283 B1**
(45) Date of publication and mention of the grant of the patent: **30.12.2020**
(21) Application number: 19153819.8
(22) Date of filing: 25.01.2019
(51) Int. Cl.: H01L 25/075, H01L 33/62

(54) **LIGHT EMITTING DIODE PANEL AND METHOD FOR MANUFACTURING THE LIGHT EMITTING DIODE PANEL**
LEUCHTDIODENTAFEL UND VERFAHREN ZUR HERSTELLUNG DER LEUCHTDIODENTAFEL
PANNEAU DE DIODE ÉLECTROLUMINESCENTE ET PROCÉDÉ DE FABRICATION DU PANNEAU DE DIODE ÉLECTROLUMINESCENTE

(30) Priority: 29.01.2018 KR 20180010895
(43) Date of publication of application: 31.07.2019
(73) Proprietor: Samsung Electronics Co., Ltd., Suwon-si, Gyeonggi-do, 16677 (KR)
(72) Inventor: SHIN, Sangmin, Gyeonggi-do 16677 (KR); LEE, Hoseop, Gyeonggi-do 16677 (KR); PARK, Sangyoung, Gyeonggi-do, 16677 (KR)
(74) Representative: Taor, Simon Edward William

(56) References cited:
- WO-A2-2016/100657
- KR-A- 20170 101 064
- US-A1- 2017 179 192

## Description

### CROSS-REFERENCE TO RELATED APPLICATION

This application is based on and claims priority under 35 U.S.C. § 119(a) to Korean Patent Application No. 10-2018-0010895, filed on January 29, 2018, in the Korean Intellectual Property Office.

### BACKGROUND

### 1. Field

The disclosure relates to a display panel and a method for manufacturing same. More particularly, the disclosure relates to a light emitting diode (LED) panel and a method for manufacturing same.

### 2. Description of Related Art

Unlike liquid crystal display (LCD) panels, which display an image using a backlight and an LCD, LED panels illuminate LEDs and directly display an image without the need for a backlight layer or a liquid crystal layer. LED panels may use three LEDs respectively including a red (R) LED, a green (G) LED, and a blue (B) LED to constitute each pixel.

LED panels may be manufactured by bonding the respective R, G and B LEDs to a thin-film transistor (TFT) backplane for each type by a stamper. In this case, the respective R, G, and B LEDs are manufactured in different ways and have different thicknesses, whereas areas to which the respective LEDs are bonded on the related-art TFT backplane are formed to have the same height, which may be a problem.

For example, if the R LED is thinner than the G LED and the B LED, the relatively thin R LED may be easily broken into pieces as compared with the Green and B LEDs. If the R LED is bonded first (to the TFT backplane) and then, the G and B LEDs are bonded, the relatively thin R LED may receive interference of the stamper, etc. in the subsequent process (that is, process of bonding G and B LEDs), thus increasing the chances that the R LED will be broken. In addition, if the R LED is bonded the last to eliminate interference from the subsequent process, the R LED may be unbonded, and if a pressure of the stamper is increased too much to bond the R LED, the R LED may be broken into pieces.

The above information is presented as background information only to assist with an understanding of the disclosure. No determination has been made, and no assertion is made, as to whether any of the above might be applicable as prior art with regard to the disclosure.
KR20170101064 discloses an emitting device, a semiconductor device, a light emitting device package, a light emitting module, a display device, or a lighting device. US2017179192 discloses a semiconductor device with thin-film transistor circuitry monolithically integrated with other non-TFT functional devices.
WO2016/100657 discloses an emissive display panel employing a light emitting device array on a backplane.

### SUMMARY

Provided are a light emitting diode (LED) panel which is formed such that LED bonding areas on the TFT backplane have different steps according to LED types, and a method for manufacturing the LED panel.
In accordance with an aspect of the disclosure, a method for manufacturing an LED panel is provided according to claim 1. The optional features are set out in claims 2 to 7.

In accordance with another aspect of the disclosure, an LED panel is provided according to claim 8. The optional features are set out in claims 9 to 13.

As described above, according to the various embodiments, problems of LED unbonding or LED crack that may occur due to a difference of thickness according to LED types in the process of bonding the LED to the TFT backplane can be minimized.

Other aspects, advantages, and salient features of the disclosure will become apparent to those skilled in the art from the following detailed description, which, taken in conjunction with the annexed drawings, discloses various embodiments of the disclosure.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a diagram illustrating a pixel structure of a TFT backplane, according to an embodiment;
FIG. 2 is a diagram illustrating an LED bonding area on one sub pixel area included in the TFT backplane, according to an embodiment;
FIGS. 3A is a diagram illustrating problems with a related art;
FIGS. 3B is a diagram illustrating problems with a related art;
FIGS. 3C is a diagram illustrating problems with a related art;
FIGS. 4A is a diagram illustrating a method for manufacturing an LED panel, according to various embodiments;
FIGS. 4B is a diagram illustrating a method for manufacturing an LED panel, according to various embodiments;
FIGS. 5A is a diagram illustrating a method for manufacturing a TFT backplane, according to various embodiments;
FIGS. 5B is a diagram illustrating a method for manufacturing a TFT backplane, according to various embodiments;
FIGS. 5C is a diagram illustrating a method for manufacturing a TFT backplane, according to various embodiments;
FIGS. 5D is a diagram illustrating a method for manufacturing a TFT backplane, according to various embodiments;
FIGS. 6A is a diagram illustrating an embodiment for preventing a short-circuit of anode and cathode terminals when an LED is bonded to the TFT backplane;
FIGS. 6B is a diagram illustrating an embodiment for preventing a short-circuit of anode and cathode terminals when an LED is bonded to the TFT backplane;
FIGS. 6C is a diagram illustrating an embodiment for preventing a short-circuit of anode and cathode terminals when an LED is bonded to the TFT backplane; and
FIG. 7 is a diagram illustrating a TFT backplane, according to another embodiment.

### DETAILED DESCRIPTION

Specific embodiments are illustrated in the drawings and are described in detail in the detailed description. However, it is to be understood that the disclosure is not limited to a specific embodiment, but the invention is defined by the appended claims.

In relation to explanation of the drawings, same or similar drawing reference numerals may be used for similar constituent elements.

Further, when it is mentioned that one element (e.g., first element) is operatively or communicatively coupled with or connected to another element (e.g., second element), it may be understood as including all the examples where each of the elements is directly coupled or indirectly coupled via yet another element (e.g., third element).When it is mentioned that one element (e.g., first element) is "directly coupled" with or "directly connected to" another element (e.g., second element), it may be understood that there is no element (e.g., third element) present between the element and the other element.

Herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

The terms used in various embodiments of the disclosure are just for the purpose of describing particular embodiments and are not intended to limit the disclosure. In addition, the singular expression does not limit the disclosure to have a single component or step. Instead, the disclosure may comprise multiple components or steps even if described in singular expression.

All of the terms used herein including technical or scientific terms have the same meanings as those generally understood by a person of ordinary skill in the related art unless they are defined otherwise. The terms defined in a generally used dictionary should be interpreted as having the same meanings as the contextual meanings of the relevant technology and should not be interpreted as having ideal or exaggerated meanings unless they are clearly defined in the various embodiments. According to circumstances, even the terms defined in the embodiments should not be interpreted as excluding the embodiments of the disclosure.

Hereinafter, various embodiments of the disclosure will be described in detail with reference to the accompanying drawings.

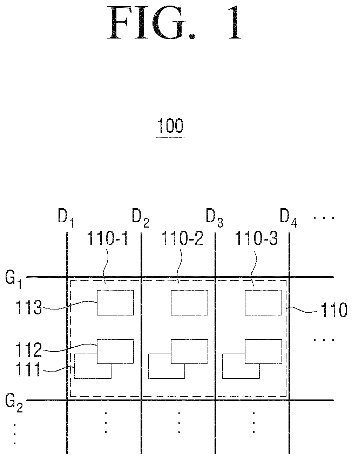

FIG. 1 is a diagram illustrating a pixel structure of a thin-film transistor (TFT) backplane 100, according to an embodiment. As illustrated in FIG. 1, the TFT backplane 100 may have a structure in which a plurality of sub pixel areas 110-1, 110-2 and 110-3 defined by gate lines Gi, G2, ..., Gn and data lines D1, D2, ..., Dn are arranged in a checkerboard form.

Here, the number of the plurality of sub pixel areas 110-1, 110-2 and 110-3 included in a single pixel area 110 is the same as the number of sub pixels per pixel (three in the example of FIG. 1). For example, the plurality of sub pixel areas 110-1, 110-2, and 110-3 may correspond to an R sub pixel, a G sub pixel, and a B sub pixel, respectively. In this case, an R LED, a G LED, and a B LED may be respectively bonded to the sub pixel areas 110-1, 110-2, and 110-3 and included in one pixel (or unit pixel) of the LED panel.

For example, the sub pixel area 110-1 may include at least one transistor 111 and two pixel electrodes 112 and 113. In FIG. 1, the two pixel electrodes 112 and 113 are implemented as a power electrode 112 and a common electrode 113, and one transistor 111 is provided only on the power electrode 112 side. However, according to embodiments, the two pixel electrodes may be respectively implemented as a power electrode and the two transistors may be provided on the respective sides of the two power electrodes. The remaining sub pixel areas 110-2 and 110-3 may be similarly arranged.

On the two pixel electrodes 112 and 113, the corresponding LED may be bonded and one sub pixel of the LED panel may be formed. Here, an area to which the LED is bonded on the TFT backplane 100 may be referred to as an LED bonding area. In this case, the TFT backplane 100 may be a structure in which a power is supplied to at least one of the two pixel electrodes 112 and 113 and the bonded LED emits light.

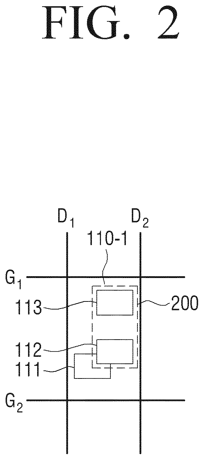

FIG. 2 illustrates an LED bonding area 200 on one sub pixel area 110-1 included in the TFT backplane 100. For example, one LED from among the R, G, and B LEDs may be bonded to the LED bonding area 200 to constitute one sub pixel of the LED panel.

The remaining sub pixel areas 110-2 and 110-3 may respectively include the LED bonding area as illustrated in FIG. 2 as well. Accordingly, the R, G and B LEDs may be respectively bonded to the LED bonding areas of the sub pixel areas 110-1, 110-2, and 110-3 to constitute one pixel of the LED panel.

As described above, the R, G, and B LEDs may be respectively manufactured in different ways, and thus the thicknesses thereof may be different. Accordingly, in a case that the LED bonding areas formed on the TFT backplane all have the same height, a problem in which the LED is unbonded or broken in the LED bonding process may occur.

According to an embodiment, the LED bonding areas included in the TFT backplane 100 may be formed on the TFT backplane 100 to have different heights according to types of LED to be bonded. In addition, a relatively thin LED may be bonded to an LED bonding area of a relatively low height from among the LED bonding areas to constitute an LED panel. By manufactured an LED panel this way, problems occurring in the LED bonding process according to the related art may be overcome.

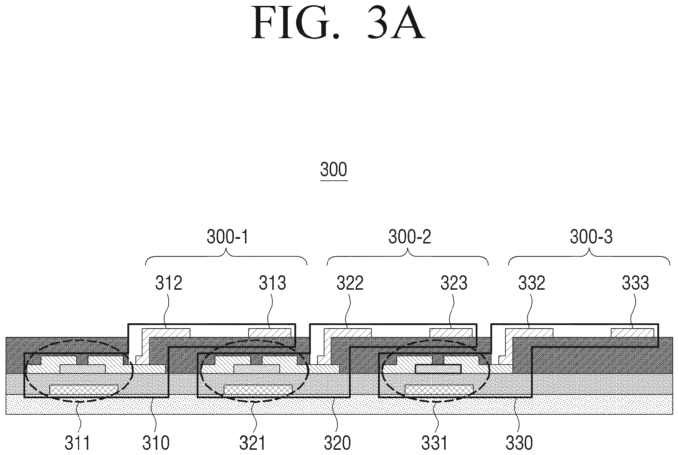

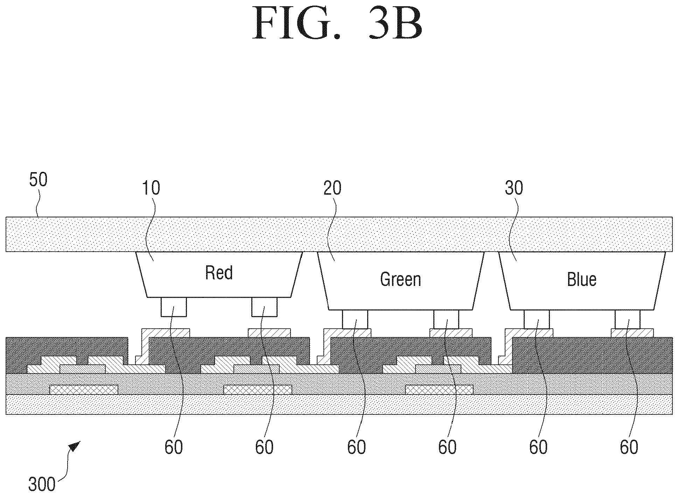

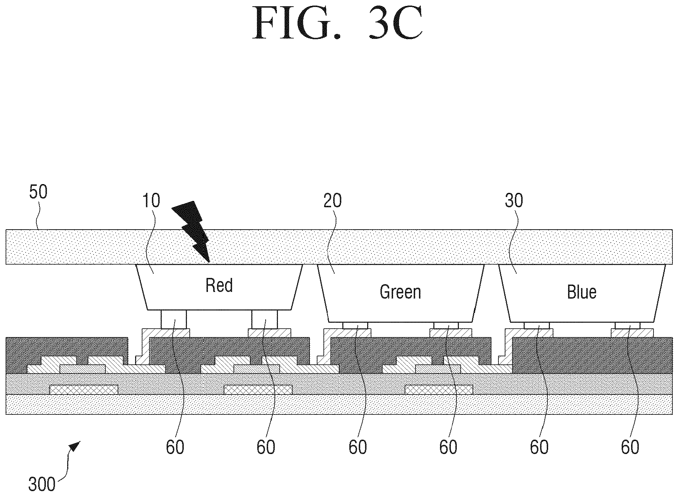

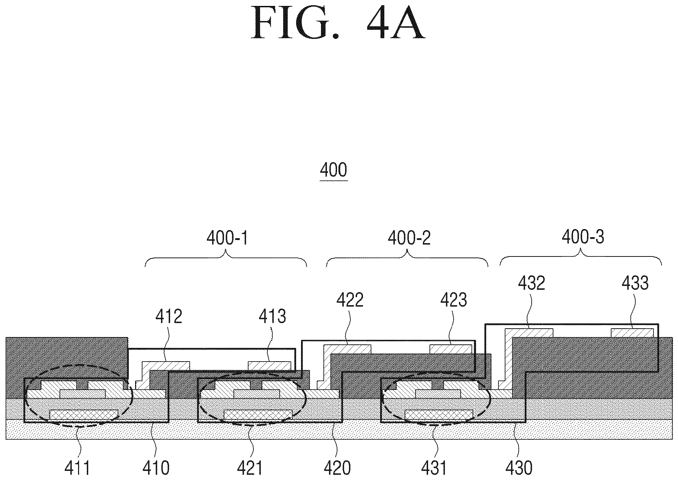

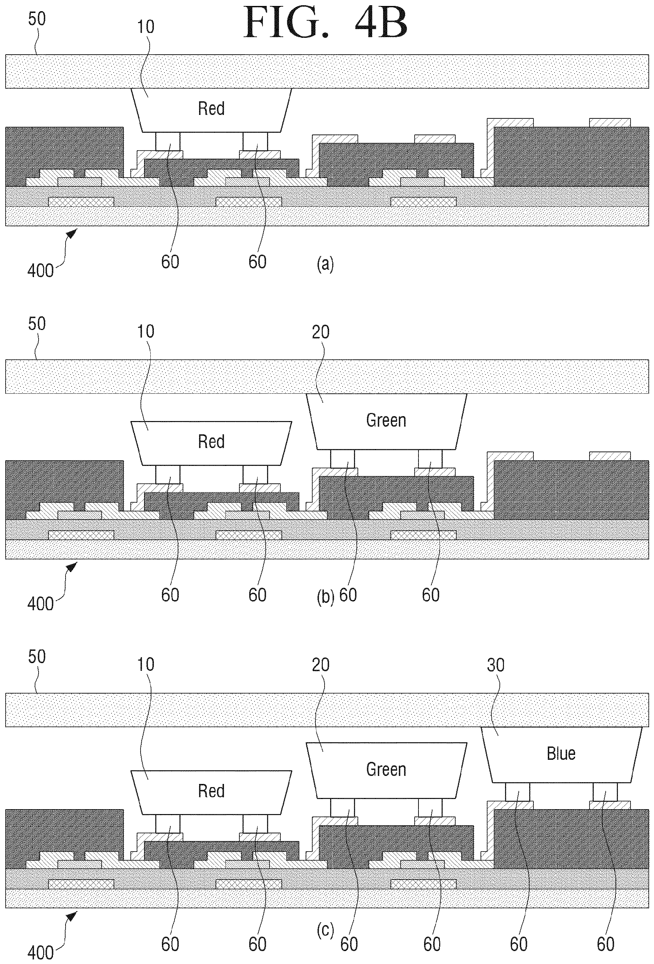

The problems of the related art will be described in greater detail below with reference to FIGS. 3A, 3B, and 3C, and an LED panel manufacturing process according to an embodiment will be described with reference to FIGS. 4A and 4B.

FIGS. 3A, 3B, and 3C are diagrams illustrating problems with a related art. FIG. 3A is a cross-sectional view of one pixel area included in a related-art TFT backplane 300.

As illustrated in FIG. 3A, one pixel area of the related-art backplane 300 may include three sub pixel areas 310, 320, and 330. The first sub pixel area 310 may include a transistor 311 and two pixel electrodes 312 and 313. The second sub pixel area 320 may include a transistor 321 and two pixel electrodes 322 and 323. The third sub pixel area 330 may include a transistor 331 and two pixel electrodes 332 and 333.

Here, the sub pixel areas 310, 320, and 330 may respectively include LED bonding areas 300-1, 300-2 and 300-3 to which an LED is bonded. As illustrated the respective LED bonding areas 300-1, 300-2, and 300-3 of the related-art TFT backplane 300 are formed at a uniform height regardless of types of LED to be bonded.

FIG. 3B illustrates a process of manufacturing an LED panel by bonding an LED onto the related-art TFT backplane 300. The LED panel may be manufactured by sequentially bonding an LED to the LED bonding areas 300-1 to 300-3 on the TFT backplane 300 using a stamper 50. In this case, the respective LEDs 10, 20, and 30 may be bonded onto the respective pixel electrodes 312/313, 322/323, and 332/333 in the LED bonding areas 300-1 to 300-3 through a metal bump 60 which is a conductive melting material.

As described above, a difference of thickness may be present among LEDs by type and thus, in a case that an LED is bonded to the LED bonding areas 300-1 to 300-3 of the related-art TFT backplane 300 of the same height, a problem may occur in the bonding process.

Referring to FIG. 3B, the R LED 10 is thinner than the G LED 20 and the B LED 30. This is due to a difference of LED epitaxial growth. For example, in a case that the R LED 20 uses gallium arsenide (GaAs) to proceed with the LED epitaxial growth process and that the G and B LEDs 20 and 30 use gallium nitride (GaN) to proceed with the LED epitaxial growth process, an ultimate thickness of the R LED 10 may be thin as compared with thicknesses of the G and B LEDs 20 and 30 as illustrated in FIG. 3B.

When bonding the respective R, G, and B LEDs to the TFT backplane 300, a bonding pressure of the stamper 50 remains unchanged and thus, in a case that the relatively thick G and B LEDs 20 and 30 are bonded first and then, the R LED 10 is bonded at the same bonding pressure, a problem that the relatively thin R LED 10 is unbonded may occur.

FIG. 3C illustrates a problem that may occur when a bonding pressure of a stamper is increased to resolve the unbonding problem of the R LED 10 as in FIG. 3B. The R LED 10 is fragile because it is thin and has weak properties. Accordingly, in a case that a stamper pressure is increased to bond the R LED 10, a crack may occur in the R LED 10 as illustrated in FIG. 3C. Although it is possible to set an appropriate stamper pressure at which the R LED 100 is bonded without cracking, it is not easy to find the appropriate stamper pressure, and even if the pressure is changed only slightly, an unbonding or cracking of the R LED may occur.

In order to try and solve these problems, bonding the R LED 10 first and then bonding G and B LEDs 20 and 30 has been considered in the related art. However, this may increase the chances that the bonded R LED 10 will be interrupted in the subsequent process, that is, the process of bonding the G LED 20 and the B LED 30, which is not desirable.

In contrast, according to an embodiment, the LED bonding area of the TFT backplane may be formed at different heights according to a type of an LED to be bonded, and the relatively thin LED may be bonded to the LED bonding area at a relatively low height to manufacture an LED panel, and thereby the problem described above may be overcome.

FIGS. 4A and 4B are diagrams illustrating a method for manufacturing an LED panel, according to various embodiments.

FIG. 4A is a cross-sectional view of one pixel area included in the TFT backplane, according to an embodiment. As illustrated in FIG. 4A, one pixel area of the TFT backplane 400 according to an embodiment may include three sub pixel areas 410, 420, and 430, and the respective sub pixel areas 410, 420, and 430 may include one transistor 411, 421, and 431 and two pixel electrodes 412/413, 422/423, and 432/433. In this case, the respective pixel electrodes may include an anode electrode 412, 422 and 432, and a cathode electrode 413, 423, and 433.

In the TFT backplane 400 according to an embodiment, the LED bonding heights 400-1, 400-2, and 400-3 may be formed at different heights unlike the related-art TFT backplane 300 of FIG. 3A. For example, the LED bonding area 400-1 may be formed at the lowest level, the LED bonding area 400-2 may be formed at the intermediate level, and the LED bonding area 400-3 may be formed at the highest level among the bonding areas.

However, embodiments are not limited to any specific examples. That is, when it is assumed that heights of the LED bonding areas 400-1, 400-2, and 400-3 on the TFT backplane 400 are respectively represented as A, B, and C, it may be formed as shown in A < B < C as illustrated in FIG. 4A, but may be, in an implementation, as shown in A < B = C, A = B > C, or A > B > C.

FIG. 4B illustrates a process of manufacturing an LED panel by bonding R, G, and B LEDs onto the LED bonding areas 400-1 to 400-3 of the TFT backplane.

For example, according to an embodiment, a relatively thin LED from among a plurality of LEDs may be bonded to an LED bonding area of a relatively low level from among the plurality of LED bonding areas.

For example, while thicknesses of the R, G, and B LEDs 10, 20, and 30 are represented as a, b, and c, respectively, when it is assumed that a < b = c, or that a < b < c, a relatively thin R LED 10 may, as illustrated in section (a) of FIG. 4B, be bonded to the LED bonding area 400-1, and the G LED 20 and the B LED 30 may be sequentially bonded to the LED bonding areas 400-2 and 400-3, respectively, as illustrated in sections (b) and (c) of FIG. 4B.

In FIG. 4B, when it is assumed that the heights of the LED bonding areas 400-1, 400-2, and 400-3 are represented as A, B, and C, respectively, the TFT backplane 400 is formed such that A < B < C as illustrated in FIG. 4A, but is not limited thereto. For example, even in a case of a TFT backplane in which the heights of the LED bonding areas 400-1 to 400-3 have a relationship of A < B = C, as illustrated in FIG. 4B, the R, G, and B LEDs 10, 20, and 30 may be sequentially bonded to the corresponding LED bonding area.

In a case of a TFT backplane on which the LED bonding areas 400-1 to 400-3 have heights of a relationship of A = B > C, or A > B > C, unlike FIG. 4B, the relatively thinnest R LED 10 may be bonded to the LED bonding area 400-3 of the relatively lowest level, and the G LED 20 and the B LED 30 may be sequentially bonded to the LED bonding area 400-2 and the LED bonding area 400-1, respectively.

According to the various embodiments, the LED bonding areas 400-1, 400-2 and 400-3 included in the TFT backplane 400 may be formed at different heights according to a type of LED to be bonded thereto, and a relatively thin LED may be bonded to an LED bonding area of a relatively low height, thus eliminating the possibility of interference by the stamper 50 in the LED bonding process. Accordingly, an LED bonding defect or an LED cracking problem by a stamper pressure can be resolved.

With regard to the planar view of the TFT backplane 400 illustrated in FIGS. 4A and 4B, the transistors 411, 421 and 431 are different in position from those of FIG. 1, but this is only a difference in an implementation which is irrelevant to the gist of the disclosure.

In the example described above, the R, G, and B LEDs 10, 20 and 30 are included in one pixel, and when it is assumed that the thicknesses of the LEDs are represented as a, b, and c, respectively, the relationship thereof are a < b = c or a < b < c. However, the example is not limited thereto. For example, one pixel of the LED panel may include three or more LEDs, and a relationship among the respective LEDs may differ depending on LED manufacturing processes.

That is, a type and the number of LEDs included in one pixel of an LED panel, and a relationship of thicknesses between LEDs may differ according to embodiments. However, if a relatively thin LED is bonded to the LED bonding area 400-1 of a relatively low level, the case may be included in the technical concept of the disclosure.

The description of other processes required for manufacturing an LED panel is omitted herein because they would obscure the gist of the disclosure.

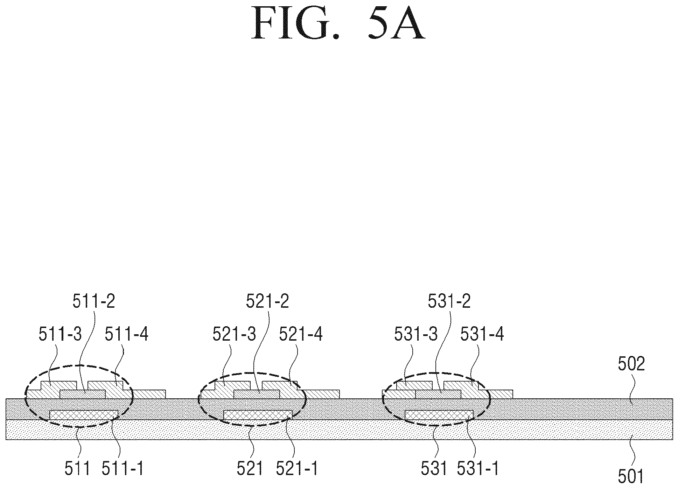

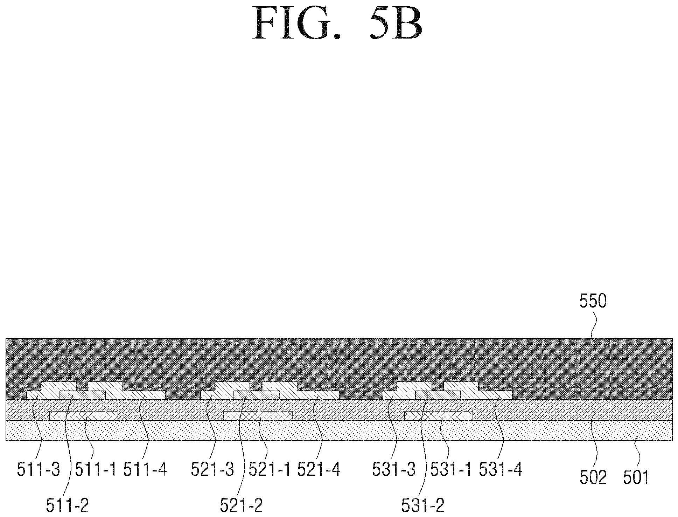

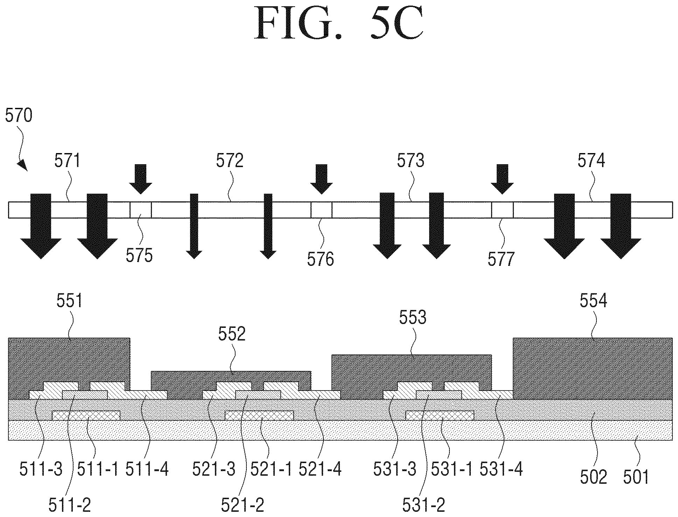

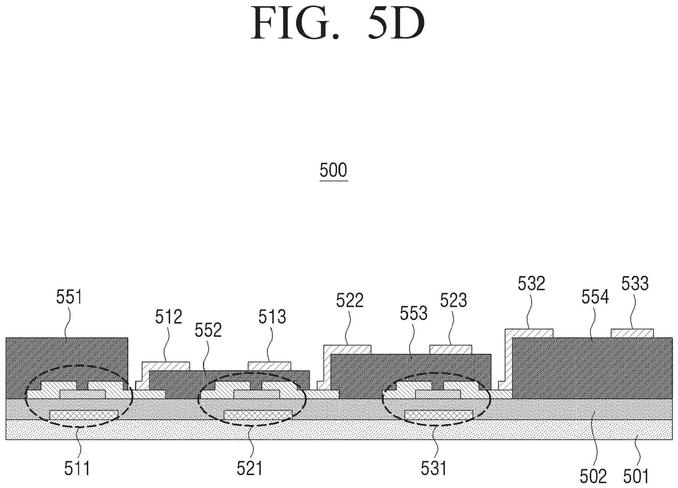

A method for manufacturing a TFT backplane according to an embodiment will be described below. FIGS. 5A, 5B, 5C, 5D are diagrams sequentially illustrating a method for manufacturing a TFT backplane 500, according to various embodiments. FIGS. 5A, 5B, 5C, and 5D illustrate a process of generating one pixel area including three sub pixel areas in the TFT backplane 500.

A process of manufacturing the TFT backplane 500, which is also referred to as a TFT substrate, a TFT array, or a TFT panel, may first include forming TFTs 511, 521, and 531 respectively corresponding to sub pixels as illustrated in FIG. 5A, through a related-art TFT process.

For example, the respective TFTs 511, 521, and 531 may be manufactured by a TFT process sequentially including forming gate electrodes 511-1, 521-1 and 531-1 on the substrate 501, forming an insulator film 502 and semiconductor films 511-2, 521-2, and 531-2 on the gate electrodes 511-1, 521-1, and 531-1, and then forming source electrodes 511-3, 521-3, and 531-3 and drain electrodes 511-4, 521-4, and 531-4.

In this case, the substrate 501 may be implemented as a glass. However, depending on circumstances, polyimide, polyethylene terephthalate (PET), etc. may be used. In addition, the semiconductor films 511-2, 521-2, and 531-2 may be made of at least one material of amorphous silicon (a-Si), low-temperature poly silicon (LTPS), and oxide.

The gate electrodes 511-1, 521-1, and 531-1 formed on the substrate 501 may function to control a current to flow or not to flow in the semiconductor films 511-2, 521-2, and 531-2, and the insulator film 502 may serve to separate the semiconductor films 511-2, 521-2 and 531-2. In addition, the source electrodes 511-3, 521-3, and 531-3 and the drain electrodes 511-4, 521-4, and 531-4 may function as a data electrode which supplies and receives electrons through the semiconductor films 511-2, 521-2, and 531-2.

The respective TFTs 511, 521, and 531 may serve as a sort of switch controlling a light emission intensity, light emission time, etc. of the corresponding LED. FIG. 5A illustrates, by way of example, the TFT having an inverted staggered structure, but the embodiment is not limited thereto. As another example, the TFT having a staggered structure, a coplanar structure, an inverted coplanar structure, or the like may also be used.

When the TFTs 511, 521, and 531 respectively corresponding to the sub pixels are provided, as illustrated in FIG. 5B, an organic layer 550 may be formed on the data electrodes (that is, the source electrodes 511-3, 521-3, and 531-3) and the drain electrodes 511-4, 521-4, and 531-4.

For example, the organic film 550 may be evenly coated on the data electrodes. In general, a deposition process and a coating process may be used to form an insulator film or an organic film layer. However, according to an embodiment, it is necessary that the LED bonding areas are formed at different heights as described above, and thus it is desirable to form the organic film 550 through the coating process rather than through the deposition process.

A photosensitive material, that is, photo resist (PR), may be used for the organic film 550. In this regard, a variety of acrylic materials may be used for the organic film 550. For example, a transparent organic film (e.g., transparent organic layer material used in a manufacturing process of related-art LCD panels), an opaque organic film (e.g., black matrix), or Polyimide may be used.

The various embodiments relate to an LED panel directly displaying an image by illuminating an LED, and thus it is desirable to form an opaque organic film (black matrix) on a data electrode to prevent a light emitted from an LED from being reflected off the TFT backplane 500. This is clearly different from forming a black matrix layer on a color filter in the LCD panel manufacturing process in terms of objective and effect. However, the example is not limited thereto, and depending on circumstances, an organic film such as a transparent organic film and Polyimide may be used as well.

When a TFT substrate with which the organic film 550 is flat-coated is provided, as illustrated in FIG. 5C, a light is radiated to the organic film 550 through a mask 570 having areas with different penetration ratios so that the LED bonding areas 552, 553, and 554 are formed at different heights according to a type of LED to be bonded thereto.

As described above, a Photo Resist is used for the organic film 550, and thus, when a light is radiated to the organic film 550 through the mask 570 having the areas 571 to 577 with different penetration ratios, an intensity of light radiated to the organic film 550 changes according to penetration ratios and thus, based on a penetration ratio of the respective parts 571 to 577, the corresponding organic film 550 may be formed at different heights.

FIG. 5C illustrates a case in which the organic film 550 is a negative Photo Resist. The negative Photo Resist refers to a material which is removed much during development as the radiated light is weak. FIG. 5C illustrates a mask 570 that includes, for example, areas 571 and 574 with a 100% penetration ratio, an area 573 with a 70% penetration ratio, an area 572 with a 50% penetration ratio, and areas 575, 576, and 577 with a 0% penetration ratio.

Accordingly, when the light is radiated through the mask 570 and developed, the organic film 550 may not be removed from the parts of organic films 551 and 554 corresponding to the areas 571 and 574, may be removed from the part of organic film 553 corresponding to the area 573, and further removed from the part of organic film 552 corresponding to the area 572. In this sequence, the organic film is formed at a gradually lower height. No light may be radiated to organic film parts corresponding to areas 575, 576, and 577, and thus it may be identified that the entire organic film 550 is removed.

In FIG. 5C, the organic film 550 is a negative Photo Resist. However, a positive Photo Resist which is removed much during development as a light radiation increases may be used as an organic film.

As described above, a light is radiated through the mask 570 with different penetration ratios and the organic films 552, 553, and 554 is formed at different heights for each LED bonding area, as illustrated in FIG. 5D, the pixel electrodes 512/513, 522/523, and 532/533 may be respectively formed on the organic films 552, 553, and 554 formed at different heights, thereby manufacturing the TFT backplane 500 according to an embodiment. In this case, the respective pixel electrodes may include an anode electrode 512, 522, and 532, and a cathode electrode 513, 523, and 533.

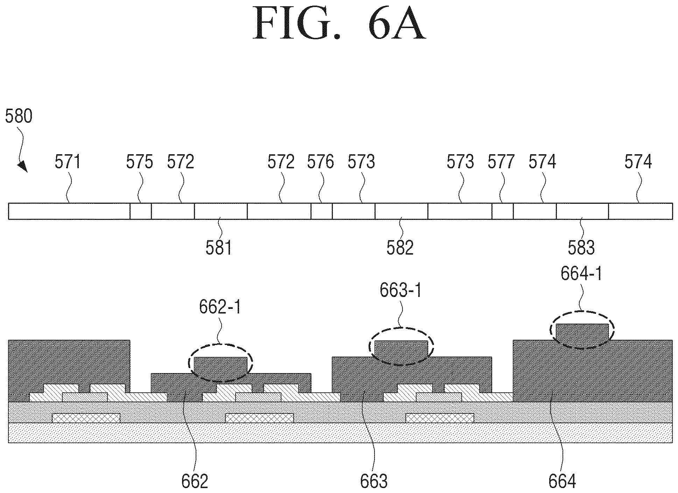

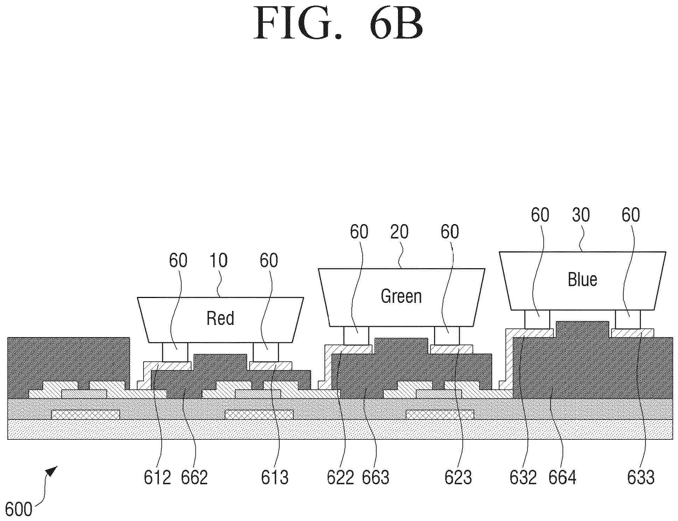

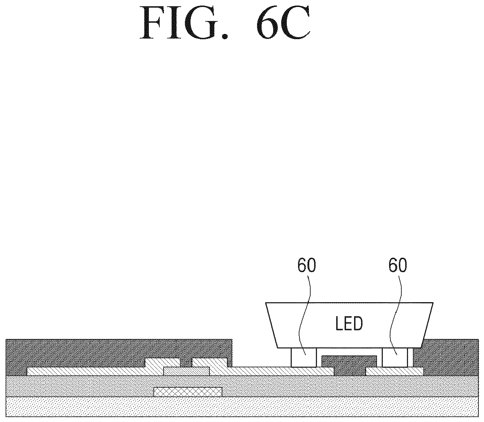

FIGS. 6A, 6B, and 6C are diagrams illustrating an embodiment for preventing anode and cathode terminals from being short-circuited when an LED is bonded to the TFT backplane.

According to an embodiment, an LED bonding area of a TFT backplane may further include an organic film of a predetermined height between two pixel electrodes (anode and cathode).

As described above, onto the two pixel electrodes, the corresponding LED may be bonded so that one sub pixel of an LED panel may be formed. That is, the anode/cathode terminals of the LED may be respectively bonded to the anode/cathode terminals of the pixel electrode. However, in this case, the LED included in one sub pixel of the LED panel is very small in size, and thus it is likely that a short-circuit will occur between the anode terminal and the cathode terminal.

Accordingly, an organic film of a predetermined height may be formed between the anode terminal and the cathode terminal on the LED bonding area, and thereby a short-circuit of the anode and cathode terminals during LED bonding can be prevented.

FIG. 6A illustrates a method for further forming an organic film of a predetermined height between two pixel electrodes included in the respective LED bonding areas. As described with reference to FIG. 5C, a light may be radiated to the organic film (photo resist) through a mask including areas with different penetration ratios, thereby forming an organic film of different heights on the TFT backplane.

Accordingly, as illustrated in FIG. 6A, penetration ratios of the areas 581, 582, and 583 of the mask 580 corresponding to an area between positions at which the two pixel electrodes are to be formed on the TFT backplane may be appropriately selected to thereby respectively form the organic films 662, 663, and 664 further including the parts of organic film 662-1, 663-1, and 664-1 of predetermined heights between the positions at which the two pixel electrodes are to be formed.

Thereafter, the pixel electrodes 612/613, 622/623, and 632/633 may be respectively formed on the organic film 662, 663, and 664 corresponding to the LED bonding area may be formed, and thereby, as illustrated in FIG. 6B, a TFT backplane 600 further including an organic film of a predetermined height between the two pixel electrodes 612/613, 622/623, and 632/633 may be manufactured.

In this case, as illustrated in FIG. 6B, even in a case that the LEDs 10, 20 and 30 are respectively bonded to the pixel electrodes 612/613, 622/623, and 632/633 through a metal bump 60 which is a conductively melting material, a short-circuit between the pixel electrodes 612/613, 622/623, and 632/633 can be prevented.

In FIGS. 6A and 6B, an organic film of a predetermined height is further included in between two pixel electrodes included in the TFT backplane having LED bonding areas with different steps according to a type of LED to be bonded thereto, but the example is not limited thereto. That is, as illustrated in FIG. 6C, an organic film of a predetermined height may be formed between pixel electrodes included in a related-art TFT backplane having LED bonding areas without steps, and thereby it is possible to prevent a short-circuit between pixel electrodes that may occur during LED bonding.

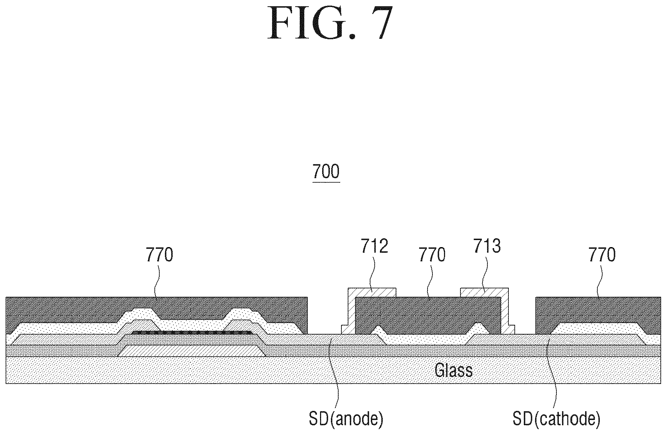

In the example above, a case in which a TFT backplane includes an additional pixel electrode is described. However, the technical concept according to the various embodiments is not limited thereto. For example, the technical concept of the disclosure may be applicable to a case in which a TFT backplane 700 directly using a source/drain (SD) layer as a pixel electrode, that is, anode/cathode terminals, as illustrated in FIG. 7.

Even in a case in which the source/drain (SD) layer is directly used as anode/cathode terminals as illustrated in FIG. 7, the organic film 770 may be coated on top of the SD layer and the light may be radiated through a mask including areas with different penetration ratios, and thereby an organic film with different heights for each LED bonding area may be formed. Accordingly, by forming an additional pixel electrode 712 and 713 on the organic film of different heights, it is possible to manufacture a TFT backplane with different heights according to a type of LED to be bonded thereto. In FIG. 7, for convenience of explanation, only one sub pixel area is illustrated. However, an LED bonding area included in surrounding another sub pixel area may be formed at different heights from the organic film 770.

Hereinabove, an LED, an organic LED (OLED), a micro LED, etc. may be bonded to the LED bonding area, but the example is not limited thereto.

As described above, according to the various embodiments, problems of LED unbonding or LED cracking that may occur due to a difference of thickness according to LED types in the process of bonding the LED to the TFT backplane can be minimized.

The foregoing embodiments and advantages are merely example and are not to be construed as limiting the disclosure. The present teaching can be readily applied to other types of apparatuses.

## Claims

1. A method for manufacturing a light emitting diode (LED) panel, the method comprising:
providing a thin-film transistor (TFT) backplane (400,500) including a plurality of LED bonding areas (400-1,400-2,400-3,552,553,554); and
bonding a plurality of LEDs (10,20,30), corresponding to a plurality of sub pixels included in one pixel, to the plurality of LED bonding areas, respectively,
wherein the plurality of LED bonding areas have different heights on the TFT backplane according to a type of LED to be bonded thereto, and **characterised in that**, the bonding comprises bonding a relatively thin LED from among the plurality of LEDs to an LED bonding area of a relatively low height from among the plurality of LED bonding areas.

2. The method as claimed in claim 1, wherein the providing the TFT backplane comprises:
forming an insulator film (502) and a semiconductor film (511-2,521-2,531-2) on a gate electrode (511-1,521-1,531-1) formed on a substrate (501);
forming a data electrode (511-3,521-3,531-3,511-4,521-4,531-4) on the insulator film and the semiconductor film;
coating the data electrode with an organic film (550);
forming the organic film to have different heights for each LED bonding area by radiating a light onto the organic film through a mask (570) with different penetration ratios; and
forming each of the plurality of LED bonding areas by forming a pixel electrode (512/513,522/523,532/533) on the organic film formed at different heights.

3. The method as claimed in claim 2, wherein the organic film is a black matrix.

4. The method as claimed in claim 2, wherein the pixel electrode includes two electrodes, and
wherein each of the plurality of LED bonding area further includes an organic film of a predetermined height between the two electrodes.

5. The method as claimed in claim 1, wherein the bonding comprises:
bonding the relatively thin LED from among the plurality of LEDs to the LED bonding area of the relatively low height and then, bonding a relatively thick LED from among the plurality of LEDs to an LED bonding area of a relatively thick height from among the plurality of LED bonding areas.

6. The method as claimed in claim 1, wherein the TFT backplane includes a plurality of pixels each respectively including the plurality of LED bonding areas,
wherein the bonding comprises bonding the plurality of LEDs to the plurality of LED bonding areas of the plurality of pixels for each type using a stamper, and
wherein a pressure of the stamper is constant regardless of the type of LED.

7. The method as claimed in claim 1, wherein the plurality of LEDs include a red LED, a green LED, and a blue LED, and
wherein the red LED is thinner than at least one of the green LED and the blue LED.

8. A light emitting diode (LED) panel comprising:
a thin-film transistor (TFT) backplane (400) which includes a plurality of LED bonding areas (400-1,400-2, 400-3); and
a plurality of LEDs (10, 20, 30) which are respectively bonded to the plurality of LED bonding areas,
wherein the plurality of LED bonding areas are formed to have different heights on the TFT backplane according to an LED type bonded thereto, and
**characterised in that**, a relatively thin LED from among the plurality of LEDs is bonded to an LED bonding area of a relatively low height from among the plurality of LED bonding areas.

9. The LED panel as claimed in claim 8, wherein the plurality of LEDs respectively (10, 20, 30) correspond to a plurality of sub pixels included in one pixel.

10. The LED panel as claimed in claim 8, wherein the plurality of LEDs (10, 20, 30) include a red LED (10), a green LED (20), and a blue LED (30), and
wherein the red LED is thinner than at least one of the green LED and the blue LED.

11. The LED panel as claimed in claim 8, wherein the plurality of LED bonding areas respectively formed at different heights include a plurality of organic films (552, 553, 554, 662, 663, 664) of different heights formed by radiating a light through a mask with different penetration ratios onto the plurality of organic films.

12. The LED panel as claimed in claim 11, wherein the plurality of organic films (552, 553, 554) is a black matrix.

13. The LED panel as claimed in claim 11, wherein each of the plurality of LED bonding areas include two pixel electrodes (612, 613, 622, 623, 632, 633) to which the plurality of LEDs (10, 20, 30) are respectively bonded on the plurality of organic films (662, 663, 664), and an organic film (662-1, 663-1, 664-1) formed at a predetermined height between the two pixel electrodes.

## Patentansprüche

1. Verfahren zur Herstellung einer Leuchtdiodentafel (LED-Tafel [Light Emitting Diode, LED]), wobei das Verfahren Folgendes umfasst:
Bereitstellen einer Dünnschichttransistor-Rückwand (TFT-Rückwand, [Thin-Film Transistor, TFT]) (400, 500), die eine Vielzahl von LED-Bonding-Bereichen (400-1, 400-2, 400-3, 552, 553, 554) einschließt; und
Bonden einer Vielzahl von LEDs (10, 20, 30),
entsprechend einer Vielzahl von Sub-Pixeln, die in einem Pixel eingeschlossen sind, jeweils an die Vielzahl von LED-Bonding-Bereichen,
wobei die Vielzahl von LED-Bonding-Bereichen auf der TFT-Rückwand gemäß einem Typ der LED, die an diese gebondet werden soll, unterschiedliche Höhen aufweisen,
und **dadurch gekennzeichnet, dass** das Bonden das Bonden einer relativ dünnen LED aus der Vielzahl von LEDs an einen LED-Bonding-Bereich mit einer relativ niedrigen Höhe aus der Vielzahl von LED-Bonding-Bereichen umfasst.

2. Verfahren nach Anspruch 1, wobei das Bereitstellen der TFT-Rückwand Folgendes umfasst:
Bilden einer Isolatorschicht (502) und einer Halbleiterschicht (511-2, 521-2, 531-2) auf einer Gate-Elektrode (511-1, 521-1, 531-1), die auf einem Substrat (501) gebildet ist;
Bilden einer Datenelektrode (511-3, 521-3, 531-3, 511-4, 521-4, 531-4) auf der Isolatorschicht und der Halbleiterschicht;
Beschichten der Datenelektrode mit einer organischen Schicht (550);
Bilden der organischen Schicht derart, dass sie für jeden LED-Bonding-Bereich unterschiedliche Höhen aufweist, durch Strahlen eines Lichts auf die organische Schicht durch eine Maske (570) mit unterschiedlichen Penetrationsverhältnissen; und
Bilden von jedem der Vielzahl von LED-Bonding-Bereichen durch Bilden einer Pixelelektrode (512/513, 522/523, 532/533) auf der auf unterschiedlichen Höhen gebildeten organischen Schicht.

3. Verfahren nach Anspruch 2, wobei die organische Schicht eine schwarze Matrix ist.

4. Verfahren nach Anspruch 2, wobei die Pixelelektrode zwei Elektroden einschließt und
wobei jeder der Vielzahl von LED-Bonding-Bereichen ferner eine organische Schicht mit einer vorher festgelegten Höhe zwischen den zwei Elektroden einschließt.

5. Verfahren nach Anspruch 1, wobei das Bonden Folgendes umfasst:
Bonden der relativ dünnen LED aus der Vielzahl von LEDs an den LED-Bonding-Bereich mit der relativ niedrigen Höhe und danach Bonden einer relativ dicken LED aus der Vielzahl von LEDs an einen LED-Bonding-Bereich mit einer relativ hohen Höhe aus der Vielzahl von LED-Bonding-Bereichen.

6. Verfahren nach Anspruch 1, wobei die TFT-Rückwand eine Vielzahl von Pixeln einschließt, die jeweils die Vielzahl von LED-Bonding-Bereichen einschließen,
wobei das Bonden das Bonden der Vielzahl von LEDs an die Vielzahl von LED-Bonding-Bereichen der Vielzahl von Pixeln für jeden Typ unter Verwendung eines Prägegeräts umfasst und
wobei ein Druck des Prägegeräts unabhängig von dem Typ der LED konstant ist.

7. Verfahren nach Anspruch 1, wobei die Vielzahl von LEDs eine rote LED, eine grüne LED und eine blaue LED einschließt und
wobei die rote LED dünner als mindestens eine der grünen LED und der blauen LED ist.

8. Leuchtdiodentafel (LED-Tafel), die Folgendes umfasst:
eine Dünnschichttransistor-Rückwand (TFT-Rückwand) (400), die eine Vielzahl von LED-Bonding-Bereichen (400-1, 400-2, 400-3) einschließt; und
eine Vielzahl von LEDs (10, 20, 30), die jeweils an die Vielzahl von LED-Bonding-Bereichen gebondet sind,
wobei die Vielzahl von LED-Bonding-Bereichen derart gebildet ist, dass sie auf der TFT-Rückwand gemäß einem an diese gebondeten LED-Typ unterschiedliche Höhen aufweist, und
**dadurch gekennzeichnet, dass** eine relativ dünne LED aus der Vielzahl von LEDs an einen LED-Bonding-Bereich mit einer relativ niedrigen Höhe aus der Vielzahl von LED-Bonding-Bereichen gebondet ist.

9. LED-Tafel nach Anspruch 8, wobei die Vielzahl von LEDs jeweils (10, 20, 30) einer Vielzahl von Sub-Pixeln entspricht, die in einem Pixel eingeschlossen sind.

10. LED-Tafel nach Anspruch 8, wobei die Vielzahl von LEDs (10, 20, 30) eine rote LED (10), eine grüne LED (20) und eine blaue LED (30) einschließt und
wobei die rote LED dünner als mindestens eine der grünen LED und der blauen LED ist.

11. LED-Tafel nach Anspruch 8, wobei die Vielzahl von LED-Bonding-Bereichen, die jeweils mit unterschiedlichen Höhen gebildet sind, eine Vielzahl von organischen Schichten (552, 553, 554, 662, 663, 664) mit unterschiedlichen Höhen einschließt, die durch Strahlen eines Lichts durch eine Maske mit unterschiedlichen Penetrationsverhältnissen auf die Vielzahl von organischen Schichten gebildet werden.

12. LED-Tafel nach Anspruch 11, wobei die Vielzahl von organischen Schichten (552, 553, 554) eine schwarze Matrix ist.

13. LED-Tafel nach Anspruch 11, wobei jeder der Vielzahl von LED-Bonding-Bereichen zwei Pixelelektroden (612, 613, 622, 623, 632, 633), an die die Vielzahl von LEDs (10, 20, 30) jeweils auf der Vielzahl von organischen Schichten (662, 663, 664) gebondet sind, und eine organische Schicht (662-1, 663-1, 664-1), die auf einer vorher festgelegten Höhe zwischen den zwei Pixelelektroden gebildet ist, einschließt.

## Revendications

1. Procédé de fabrication d'un panneau de diodes électroluminescentes (DEL), le procédé comprenant :
la fourniture d'une face arrière de transistor en couches minces (TFT) (400, 500) incluant une pluralité de zones de liaison de DEL (400-1, 400-2, 400-3, 552, 553, 554) ; et la liaison d'une pluralité de DEL (10, 20, 30), correspondant à une pluralité de sous-pixels inclus dans un pixel, à la pluralité de zones de liaison de DEL, respectivement,
dans lequel la pluralité de zones de liaison de DEL présente différentes hauteurs sur la face arrière de TFT selon un type de DEL devant être lié à celle-ci, et **caractérisé en ce que** la liaison comprend la liaison d'une DEL relativement mince parmi la pluralité de DEL à une zone de liaison de DEL d'une hauteur relativement faible parmi la pluralité de zones de liaison de DEL.

2. Procédé selon la revendication 1, dans lequel la fourniture de la face arrière de TFT comprend :
la formation d'un film isolant (502) et d'un film à semi-conducteurs (511-2, 521-2, 531-2) sur une gâchette (511-1, 521-1, 531-1) formée sur un substrat (501) ;
la formation d'une électrode de données (511-3, 521-3, 531-3, 511-4, 521-4, 531-4) sur le film isolant et le film à semi-conducteurs ;
le revêtement de l'électrode de données avec un film organique (550) ;
la formation du film organique pour présenter différentes hauteurs pour chaque zone de liaison de DEL par le rayonnement d'une lumière sur le film organique à travers un masque (570) avec différents taux de pénétration ; et
la formation de chacune de la pluralité de zones de liaison de DEL par la formation d'une électrode de pixels (512/513, 522/523, 532/533) sur le film organique formé à différentes hauteurs.

3. Procédé selon la revendication 2, dans lequel le film organique est une matrice noire.

4. Procédé selon la revendication 2, dans lequel l'électrode de pixels inclut deux électrodes, et
dans lequel chacune de la pluralité de zones de liaison de DEL inclut en outre un film organique d'une hauteur prédéterminée entre les deux électrodes.

5. Procédé selon la revendication 1, dans lequel la liaison comprend :
la liaison de la DEL relativement mince parmi la pluralité de DEL à la zone de liaison de DEL de la hauteur relativement faible et ensuite, la liaison d'une DEL relativement épaisse parmi la pluralité de DEL à une zone de liaison de DEL d'une hauteur relativement élevée parmi la pluralité de zones de liaison de DEL.

6. Procédé selon la revendication 1, dans lequel la face arrière de TFT inclut une pluralité de pixels incluant chacun respectivement la pluralité de zones de liaison de DEL,
dans lequel la liaison comprend la liaison de la pluralité de DEL à la pluralité de zones de liaison de DEL de la pluralité de pixels pour chaque type utilisant un estampeur, et
dans lequel une pression de l'estampeur est constante quel que soit le type de DEL.

7. Procédé selon la revendication 1, dans lequel la pluralité de DEL inclut une DEL rouge, une DEL verte, et une DEL bleue, et
dans lequel la DEL rouge est plus mince qu'au moins l'une de la DEL verte et de la DEL bleue.

8. Panneau de diodes électroluminescentes (DEL) comprenant :
une face arrière de transistor en couches minces (TFT) (400) qui inclut une pluralité de zones de liaison de DEL (400-1, 400-2, 400-3) ; et
une pluralité de DEL (10, 20, 30) qui sont respectivement liées à la pluralité de zones de liaison de DEL,
dans lequel la pluralité de zones de liaison de DEL est formée pour présenter différentes hauteurs sur la face arrière de TFT selon un type de DEL lié à celle-ci, et **caractérisé en ce qu'**une DEL relativement mince parmi la pluralité de DEL est liée à une zone de liaison de DEL d'une hauteur relativement faible parmi la pluralité de zones de liaison de DEL.

9. Panneau de DEL selon la revendication 8, dans lequel la pluralité de DEL respectivement (10, 20, 30) correspond à une pluralité de sous-pixels inclus dans un pixel.

10. Panneau de DEL selon la revendication 8, dans lequel la pluralité de DEL (10, 20, 30) inclut une DEL rouge (10), une DEL verte (20), et une DEL bleue (30), et
dans lequel la DEL rouge est plus mince qu'au moins l'une de la DEL verte et de la DEL bleue.

11. Panneau de DEL selon la revendication 8, dans lequel la pluralité de zones de liaison de DEL respectivement formée à différentes hauteurs inclut une pluralité de films organiques (552, 553, 554, 662, 663, 664) de différentes hauteurs formée par le rayonnement d'une lumière à travers un masque avec différents taux de pénétration sur la pluralité de films organiques.

12. Panneau de DEL selon la revendication 11, dans lequel la pluralité de films organiques (552, 553, 554) est une matrice noire.

13. Panneau de DEL selon la revendication 11, dans lequel chacune de la pluralité de zones de liaison de DEL inclut deux électrodes de pixels (612, 613, 622, 623, 632, 633) auxquelles la pluralité de DEL (10, 20, 30) est respectivement liée sur la pluralité de films organiques (662, 663, 664), et un film organique (662-1, 663-1, 664-1) formé à une hauteur prédéterminée entre les deux électrodes de pixels.
